# EUROPEAN PATENT SPECIFICATION

(11) **EP 4 113 591 B1**
(45) Date of publication and mention of the grant of the patent: **05.11.2025**
(21) Application number: 21183389.2
(22) Date of filing: 02.07.2021
(51) Int. Cl.: H01L 23/32, G06N 10/40

(54) **HOLDER AND MOUNTING METHOD FOR QUANTUM DEVICE**
VORRICHTUNG UND VERFAHREN ZUM HALTEN EINES QUANTENBAUTEILS
SUPPORT ET MÉTHODE DE MONTAGE D'UN DISPOSITIF QUANTIQUE

(43) Date of publication of application: 04.01.2023
(73) Proprietor: QDevil ApS (a QM company), QM Technologies ApS, 2750 Ballerup (DK)
(72) Inventor: Andresen, Søren, 2750 Ballerup (DK); Kann, Peter Ulrik, 2750 Ballerup (DK); von Soosten, Merlin, 2750 Ballerup (DK)
(74) Representative: Inspicos P/S

(56) References cited:
- US-A1- 2020 100 357
- US-B1- 11 152 707
- AVERKIN A S ET AL: "Broadband sample holder for microwave spectroscopy of superconducting qubits", REVIEW OF SCIENTIFIC INSTRUMENTS, vol. 85, 104702, 8 October 2014 (2014-10-08), XP012190912, ISSN: 0034-6748, DOI: 10.1063/1.4896830
- LIENHARD B ET AL: "Microwave Packaging for Superconducting Qubits", 2019 IEEE MTT-S INTERNATIONAL MICROWAVE SYMPOSIUM, 2-7 JUNE 2019, BOSTON, MA, 2 June 2019 (2019-06-02), pages 275 - 278, XP033579690, DOI: 10.1109/mwsym.2019.8701119

## Description

The present invention relates to a sample holder and more particularly a sample holder for a cryogenic quantum device, which sample holder is simple to mount the quantum device inside while providing the protection and cooling required by the quantum device.

A sample holder may be seen in e.g. "Microwave Packaging for Superconducting Qubits", Lienhard et al., 12 June 2019, MIT, (https://arxiv.org/abs/1906.05425) also presented in "Microwave Package Design for Superconducting Quantum Processors", Huang et al., 16 April 2021, MIT, PRX QUANTUM 2, 020306.

Other relevant technology may be seen in US2020/100357 and "Broadband sample holder for microwave spectroscopy of superconducting qubits", by Averkin A.S in Review of Scientific Instruments, vol, 85, 104702, 8 October 2014.

In a first aspect, the present invention relates to an assembly according to claim 1.

In this context, an assembly comprises a number of individual elements which may or may not be fixed to each other. Each element of the assembly may itself be monolithic or a combination of a number of elements.

A quantum device may be any type of device, often a device for use under cryogenic conditions, which may be used in relation to e.g. quantum computers. A quantum device may comprise one or more qubits, either based on superconducting junction devices embedded in one or more microwave transmission lines, single electron charging devices coupled to microwave resonators and other device concepts relying on read-out of quantum information by coupling to a microwave transmission line.

The first portion may comprise a first surface in which the first cavity is provided or from which the first cavity extends. The second portion may comprise a second surface in which the second cavity is provided or from which the second cavity extends. When the first and second portions are fixed to each other, they may be positioned with the first surface and the second surface facing each other.

The first cavity may have an opening defining a first contour, and the second cavity may have an opening defining a second contour. When the first and second portions are fixed to each other, the first and second contours may overlap, such as when projected on to a predetermined plane, such as a plane extending between the first and second portions.

The second fixing elements may be any type of fixing elements, such as screws, bolts, clamps, glue, adhesive, welds, soldering, springs, resilient elements or the like. It may be desire that the second fixing elements also perform other tasks, such as thermal transport, so bolts/screws/clamps may be preferred.

The first fixing elements fix the quantum device in relation to the first portion. These fixing elements may also be screws, bolts, clamps, glue, adhesive, welds, soldering, springs, resilient elements or the like. The fixing elements may have additional tasks as will be described below.

When fixed in relation to the first portion, the quantum device is provided over and covering at least part of the first cavity. In this context, the quantum device may have a predetermined outline, when projected to the above plane, inside which at least a portion of the outline of the first contour is provided. It may be desired that at least an active portion or circuit or elements of the quantum device are provided squarely within the first contour in that plane, as they will then be better able to interfere with, detect, receive, emit, output or the like electromagnetic radiation provided in the cavity.

In addition, when the first and second portions are fixed to each other, the quantum device is provided over and covering at least part of the second cavity. The same considerations are applicable in relation to the second cavity.

In this context, it may be desired that the device is fixed to the first portion at a surface of the portion defining a first plane. It may be desired that the first portion extends only on one side of that plane, so that the mounting or fixing of the device need not be performed in a deep cavity but at a surface where it may easily be mounted, fixed, connected to and the like.

Finally, electrical conductor(s) and/or wave guide(s) is/are connected to the quantum device and extend to outside of the first and second portions. In this manner, electrical signals or electromagnetic waves, such as radiation, RF signals or microwaves, may be transported to/from the device and/or cavity/ies.

In one embodiment, the first fixing elements comprise a flexible element biasing the quantum device toward the first portion. In this manner, the fixing may be provided using only friction. The biasing force may be tailored to the quantum device to ensure that the fixing is sufficient yet not exceeded also after a large temperature change.

The flexible element may be a plane element configured to extend between the first and second portions. Thus, the flexible element may comprise shielding elements configured to block electromagnetic waves or radiation from travelling inside the flexible element from the cavities and to surroundings of the first and second portions. The flexible element may have an outer contour, in the plane, inside of which part of or all of the first and/or second portion is provided.

The flexible element may itself be biased toward the first portion or attached thereto, such as using screws/bolts, glue, adhesives or the like.

The assembly comprises a cut-out portion at the first cavity, such as surrounding the first cavity, the quantum device being provided in the cut-out portion. In this manner, the device may be at least partly fixed in its position by edges of the cut-out portion. The portion may have a contour matching or only slightly larger than that of the device to allow the device to be received therein. It may be preferred that the cut-out portion has a first depth and the quantum device, such as outer portions thereof received in the cut-out portion, has a first height, where the first height exceeds the first depth. It may be desired that the first height is between 150% and 100% of the first depth, so that up to 33% of the device height, such as up to 20%, such as up to 10%, such as up to 5%, extends outside of the cut-out portion.

The portion of the device extending out of the cut-out portion may be engaged by the first fixing elements, such as in the form of the above flexible element(s) for obtaining the biasing. The first fixing elements may be biased toward a surface of the first portion, such as at the first surface, having the cut-out portion and the cavity. Then, due to the portion of the device extending out of the cut-out portion, a biassing may be applied of the corresponding portions of the device in a direction into or toward the cut-out portion.

It may be desired that only outer portions of the device are engaged by the first fixing means in order to e.g. allow more central portions to be exposed to e.g. radiation in the cavity.

In one situation, the flexible element comprises a printed circuit board, where the electrical conductor(s) and/or wave guide then may be provided as wave guides and/or electrically conducting elements of the printed circuit board. Wave guides and/or electrically conducting elements may be provided on a surface of and/or inside the circuit board. The circuit board may comprise a base material, such as a polymer, ceramic or composite, which is not electrically conducting on which or inside which one or more electrically conducting elements and/or wave guides are provided. Conducting elements or wave guides may be provided on a surface of a base material and covered by another material, such as to avoid emission of radiation, noise or waves and/or avoid short circuiting when contacting with other elements, such as electrically conducting elements.

The electrically conducting elements and/or wave guides preferably extend from the device, such as inside the cavity/cavities, and to outside of the first and second portions. Thus, outside equipment, such as wave or signal generators and/or wave or signal detectors may be coupled, via the electrically conducting elements and/or wave guides to the device, such as for operation, test or the like.

In one embodiment, the assembly further comprises an electromagnetic shielding surrounding a main portion of the first and second portions. A suitable shielding may be of a superconducting material. Openings may be made in the material to e.g. transfer electrical signals and/or waves to/from the electrical conductor(s) and/or wave guide(s). Openings may also be provided for cooling the assembly and/or fixing or supporting the assembly.

It may be preferred that the assembly is cooled to a temperature below 100K, such as below 50K, such as below 10K, such as below 1K. This may be desired for or required for the device to operate as desired.

Another aspect of the invention relates to a method according to claim 7.

Naturally, all embodiments, situations and considerations described above are equally valid for the present aspect of the invention.

Also, if electrical connection is desired to the device, this may be handled before step c).

Thus, step a) may be performed before step b), so that the quantum device may be fixed to the first portion without the second portion being in the way. Having fixed the quantum device to the first portion and potentially provided the electrical and/or wave connections, the second portion may be fixed to the first portion in order to assemble the assembly and enclose the device in the common cavity. The common cavity may be formed by inner surface of the first and second cavities but also additional elements, such as the above-mentioned cut-out portion, the first fixing elements and the like.

In one embodiment, step a) comprises biasing, via a flexible element, the quantum device toward the first portion. The flexible element may then be fixed to, adhered to or biased toward the first portion and may then itself bias the quantum device toward the first portion to prevent the device from displacing vis-à-vis the first portion.

As described above, the flexible element may comprise a printed circuit board comprising electrically conducing elements and/or wave guides and wherein step c) comprises electrically connecting the quantum device to the electrically conducting element(s) and/or wave guides. As explained above, the conducting elements and/or wave guides preferably extend to outside of first and second elements to allow easy connection thereto.

The first portion comprises a cut-out portion at the first cavity, and step a) comprises providing the quantum device in the cut-out portion. Subsequently, the fixing or biassing may be performed to prevent the device from leaving the cut-out portion.

In one situation, the cut-out portion has a first depth and the quantum device, such as outer portions thereof, has a first height, where the first height exceeds the first depth. This is explained above.

It may be desired to provide an electromagnetic shielding, preferably of a superconducting material, surrounding at least a main portion of the first and second portions. Openings may be provided in the shield, such as for contacting the electrically conducting elements and/or wave guides as well as for engaging the assembly for fixing or cooling it.

As explained, it may be preferred to cool the assembly to a temperature below 100K.

In the following, preferred embodiments are described with reference to the drawing,
wherein:

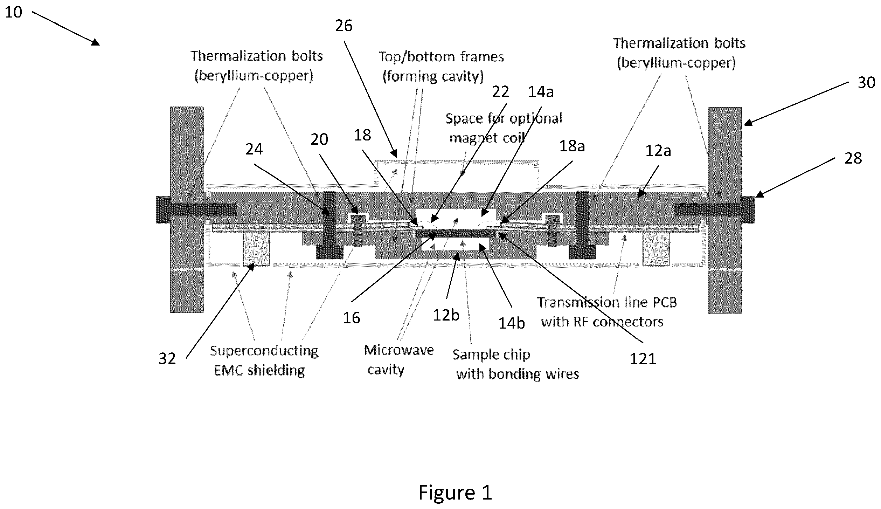

- Figure 1 illustrates a cross section through a preferred sample holder according to the invention.

In figure 1, a sample holder 10 is illustrated generally comprising an upper portion 12a and a lower portion 12b. The lower portion 12b has a cavity 14b over which a quantum device 16 is provided. The device 16 is provided in a cut-out portion 121 which may delimit movement of the device in a direction in a plane of the device. The device 16 is biased downward by a flexible element, such as a PCB, 18 clamped to the lower element 12b by screws 20.

The flexible element 18 may be a PCB comprising conducting portions which may be connected to the device either by the direct connection between the device and PCB or via other manners such as wire bonds 22.

The device may be biased toward the lower portion 12b by a biassing provided by the PCB 18. In this manner, the device may be fixed in a position without exerting a too large force on to it. The PCB may be selected or dimensioned to provide the biasing desired.

Also, the height or depth of the cut-out or indentation 121 may be selected only slightly lower than a height of the device 16, such as outer portions of the device 16, so that the PCB needs flex only slightly to provide the desired biasing.

Then, the device 16 is positioned in a combined cavity which may be used for e.g. providing microwaves to and/or receiving microwaves from the device, such as for affecting or reading-out one or more cubits on the device. The flexible element may comprise microwave antennas, microwave guides, RF antennas and/or RF conductors in order to provide such radiation to and/or remove such radiation from the device or cavity.

Thus, the electrical contacting to the device may be used for testing the device and/or operating the device. The testing may comprise feeding signals to the device and receiving signal therefrom for later analysis to derive information from or relating to the device.

The upper and lower portions are bolted to each other using bolts 24. In this manner, the upper and lower portions form a sealed space or cavity holding the device.

Electrical contacting from the outside of the assembly may be achieved via contacts or connectors 32 extending away from the PCB 18. Connectors 32 may be for electrical contacting, coaxial feeding and/or RF or microwave signals and may be achieved via connectors mounted to the PCB 18.

The PCB 18 may have on a surface thereof electrically conducting portions or traces. To prevent contact with the element 12a, another element, 18a, may be provided, which is not electrically conducting. As illustrated, the element 18a allows the PCB 18 to be exposed and contactable at the portion closest to the device 16. This contacting may be by wire bonding or direct physical contact, or contact via soldering, welding, electrically conducting glue or the like, between conductors of the PCB and of the device. It may be preferred that only the PCB 18 extends over the device so as to bias it. Alternatively, also the element 18a may be used for this purpose, such as if the PCB itself is not able to provide a sufficient biasing force.

The upper and lower portions as well as the bolts 24 may be selected to allow efficient cooling from outside of the assembly, such as a cryogenic interface 30, to the cavity and the device, as in a preferred embodiment, the device is a quantum device for operations at temperatures below 100K, such as below 10K, such as below 1K.

Especially in such situations, the assembly may further comprise a superconducting EMC shield 26 placed all around the assembly to further shield out any microwave background from reaching into the cavity.

Optimal performance of the design may be ensured by careful selection of materials and surface treatments:
1. The PCB 18 is constructed from low-loss dielectric material, e.g. PTFE or composites based thereon, with signal and ground layers made of either highly conductive copper and/or superconductive layers. The metal layers may be surface plated by either gold or superconductive metals to improve the electrical performance and avoid oxidation.
2. The upper and lower portions 12a/12b are made out of highly conductive metal, e.g. copper and/or alloys thereof. Surface plating by gold or other passivation is used to avoid oxidation and improve thermal contact. Superconducting surface plating of the cavity inner surfaces may be used to improve the electrical performance.
3. The bolts 24 that fix the portions to each other as well as any bolts 28 for mounting the assembly onto the cryogenic interface 30 are made from beryllium copper, ensuring efficient thermalization and also providing better mechanical strength than pure copper metal.
4. The superconducting EMC shields 26 on the outside of the package can be made from different superconducting materials, e.g. aluminium, niobium, titanium and/or alloys thereof. To ensure fully connected EMC shielding, the parts may be surface treated to avoid insulating oxides, e.g. by chrome passivation, zincate treatment or similar.

All ingoing parts are made from carefully selected non-magnetic metals and alloys to avoid stray magnetic fields that may disturb the performance of superconducting quantum devices. Furthermore, the whole package may be positioned in an external magnetic shielding consisting of both a superconducting can and a mu-metal enclosure. The superconductor will repel all magnetic fields by its inherent Meissner effect, whereas the mu-metal enclosure helps to avoid trapping of magnetic flux in the superconductor during cool-down.

All parts are designed with vent ports from all inner cavities 14a/14b to allow trapped air to escape to vacuum before cool-down. At the same time, no line-of-sight is allowed from the outside through both the superconducting EMC shielding and the frame parts that form the cavity. That would allow microwave background radiation to leak into the cavity. Therefore, also fully EMC tight superconducting flanges are used to seal off the connector fittings and the exposed ports around the screws for mounting onto the cryogenic interface.

## Claims (Claims for the following Contracting State(s): AT, BE, CH, DK, ES, FR, GR, IT, LI, LU, NL, SE, MC, PT, IE, SI, LT, LV, FI, RO, MK, CY, AL, TR, BG, CZ, EE, HU, PL, SK, HR, IS, MT, NO, RS, SM)

1. An assembly of a quantum device (16) and a sample holder (10), the sample holder comprising:
- a first portion (12b) comprising a first cavity (14b),
- a second portion (12a) comprising a second cavity (14b),
- first fixing elements (18),
- one or more electrical conductor(s) and/or wave guide(s) (18, 22) and
- second fixing elements (24) configured to fix the first and second portions to each other,
wherein:
- the quantum device is provided over and covering at least part of the first cavity,
- the quantum device is provided over and covering at least part of the second cavity,
- the quantum device is fixed to the first portion by the first fixing elements and
- the electrical conductor(s) and/or wave guide(s) is/are connected to the quantum device and extend to outside of the first and second portions,
**characterized in that** the first portion further comprises a cut-out portion (121) at the first cavity, the quantum device being provided in the cut-out portion.

2. An assembly according to claim 1, wherein the first fixing elements comprise a flexible element biasing the quantum device toward the first portion.

3. An assembly according to claim 2, wherein the flexible element comprises a printed circuit board (18) and wherein the electrical conductor(s) and/or wave guides are provided as electrically conducting elements and/or wave guides of the printed circuit board.

4. An assembly according to claim 1, wherein the cut-out portion has a first depth and the quantum device has a first height, where the first height exceeds the first depth.

5. An assembly according to any of the preceding claims, further comprising an electromagnetic shielding (26) surrounding a main portion of the first and second portions.

6. An assembly according to any of the preceding claims, cooled to a temperature below 100K.

7. A method of mounting a quantum device in an assembly according to any of the preceding claims, the method comprising:
a) providing the quantum device in the cut-out portion and fixing the quantum device to the first portion so as to cover at least a portion of the first cavity,
b) fixing the second portion to the first portion so that the quantum device covers at least a portion of the second cavity, and
c) providing one or more electrically conductive or wave guiding connection(s) from the device to the one or more electrical conductor(s) and/or wave guide(s).

8. A method according to claim 7, wherein step a) comprises biasing, via a flexible element, the quantum device toward the first portion.

9. A method according to claim 8, wherein the flexible element comprises a printed circuit board comprising electrically conducing elements and/or wave guides and wherein step c) comprises electrically connecting the quantum device to the electrically conducting element(s).

10. A method according to claim 7, wherein the cut-out portion has a first depth and the quantum device has a first height, where the first height exceeds the first depth.

11. A method according to any of claims 7-10, further comprising the step of providing an electromagnetic shielding surrounding a main portion of the first and second portions.

12. A method according to any of claims 7-11, further comprising the step of cooling the assembly to a temperature below 100K.

## Claims (Claims for the following Contracting State(s): DE, GB)

1. An assembly of a quantum device (16) and a sample holder (10), the sample holder comprising:
- a first portion (12b) comprising a first cavity (14b),
- a second portion (12a) comprising a second cavity (14a),
- first fixing elements comprising a printed circuit board (18) biassing the quantum device toward the first portion, the printed circuit board comprising one or more electrical conductor(s) and/or wave guide(s),
- means (20) for biasing the printed circuit board toward the first portion or attaching the printed circuit board to the first portion, and
- second fixing elements (24) configured to fix the first and second portions to each other,
wherein:
- the quantum device is provided over and covering at least part of the first cavity,
- the quantum device is provided over and covering at least part of the second cavity,
- the quantum device is fixed to the first portion by the first fixing elements and
- the electrical conductor(s) and/or wave guide(s) is/are connected to the quantum device and extend to outside of the first and second portions,
wherein the first portion further comprises a cut-out portion (121) at the first cavity, the quantum device being provided in the cut-out portion.

2. An assembly according to claim 1, wherein the cut-out portion has a first depth and the quantum device has a first height, where the first height exceeds the first depth.

3. An assembly according to any of the preceding claims, further comprising an electromagnetic shielding (26) surrounding a main portion of the first and second portions.

4. An assembly according to any of the preceding claims, cooled to a temperature below 100K.

5. An assembly according to any of the preceding claims, wherein the means for biasing the printed circuit board toward the first portion comprise screws/bolts, glue or adhesives.

6. A method of mounting a quantum device in an assembly according to any of the preceding claims, the method comprising:
a) providing the quantum device in the cut-out portion and fixing the quantum device to the first portion so as to cover at least a portion of the first cavity,
b) fixing, subsequent to step a), the second portion to the first portion so that the quantum device covers at least a portion of the second cavity, and
c) providing one or more electrically conductive or wave guiding connection(s) from the device to the one or more electrical conductor(s) and/or wave guide(s).

7. A method according to claim 6, wherein step a) comprises biasing, via the printed circuit board, the quantum device toward the first portion.

8. A method according to claim 7, wherein step c) comprises electrically connecting the quantum device to the electrically conducting element(s).

9. A method according to claim 6, wherein the cut-out portion has a first depth and the quantum device has a first height, where the first height exceeds the first depth.

10. A method according to any of claims 6-9, further comprising the step of providing an electromagnetic shielding surrounding a main portion of the first and second portions.

11. A method according to any of claims 8-10, further comprising the step of cooling the assembly to a temperature below 100K.

12. A method according to any of claims 6-11, wherein step a) comprises fixing the quantum device to the first portion using screws/bolts, glue or adhesives.

## Patentansprüche (Patentansprüche für folgende(n) Vertragsstaat(en): AT, BE, CH, DK, ES, FR, GR, IT, LI, LU, NL, SE, MC, PT, IE, SI, LT, LV, FI, RO, MK, CY, AL, TR, BG, CZ, EE, HU, PL, SK, HR, IS, MT, NO, RS, SM)

1. Anordnung einer Quantenvorrichtung (16) und eines Probenhalters (10), wobei der Probenhalter Folgendes umfasst:
- einen ersten Abschnitt (12b), der einen ersten Hohlraum (14b) umfasst,
- einen zweiten Abschnitt (12a), der einen zweiten Hohlraum (14b) umfasst,
- erste Befestigungselemente (18),
- einen oder mehrere elektrische(n) Leiter und/oder Wellenleiter (18, 22) und
- zweite Befestigungselemente (24), die dazu ausgelegt sind, den ersten und den zweiten Abschnitt aneinander zu befestigen,
wobei:
- die Quantenvorrichtung über mindestens einem Teil des ersten Hohlraums bereitgestellt ist und diesen abdeckt,
- die Quantenvorrichtung über mindestens einem Teil des zweiten Hohlraums bereitgestellt ist und diesen abdeckt,
- die Quantenvorrichtung durch die ersten Befestigungselemente an dem ersten Abschnitt befestigt ist und
- der/die elektrische(n) Leiter und/oder Wellenleiter mit der Quantenvorrichtung verbunden ist/sind und sich aus dem ersten und dem zweiten Abschnitt heraus erstreckt/erstrecken,
**dadurch gekennzeichnet, dass** der erste Abschnitt weiter einen Ausschnittabschnitt (121) bei dem ersten Hohlraum umfasst, wobei die Quantenvorrichtung in dem Ausschnittabschnitt bereitgestellt ist.

2. Anordnung nach Anspruch 1, wobei die ersten Befestigungselemente ein flexibles Element umfassen, das die Quantenvorrichtung hin zu dem ersten Abschnitt vorspannt.

3. Anordnung nach Anspruch 2, wobei das flexible Element eine Leiterplatte (18) umfasst und wobei der/die elektrische(n) Leiter und/oder Wellenleiter als elektrisch leitfähige Elemente und/oder Wellenleiter der Leiterplatte bereitgestellt sind.

4. Anordnung nach Anspruch 1, wobei der Ausschnittabschnitt eine erste Tiefe aufweist und die Quantenvorrichtung eine erste Höhe aufweist, wobei die erste Höhe die erste Tiefe übersteigt.

5. Anordnung nach einem der vorstehenden Ansprüche, die weiter eine elektromagnetische Abschirmung (26) umfasst, die einen Großteil des ersten und des zweiten Abschnitts umgibt.

6. Anordnung nach einem der vorstehenden Ansprüche, auf eine Temperatur unter 100K gekühlt.

7. Verfahren zum Montieren einer Quantenvorrichtung in einer Anordnung nach einem der vorstehenden Ansprüche, wobei das Verfahren Folgendes umfasst:
a) Bereitstellen der Quantenvorrichtung in dem Ausschnittabschnitt und Befestigen der Quantenvorrichtung an dem ersten Abschnitt, um mindestens einen Abschnitt des ersten Hohlraums abzudecken,
b) Befestigen des zweiten Abschnitts an dem ersten Abschnitt, sodass die Quantenvorrichtung mindestens einen Abschnitt des zweiten Hohlraums abdeckt, und
c) Bereitstellen einer oder mehrerer elektrisch leitfähigen/leitfähiger oder wellenleitenden/wellenleitender Verbindung(en) von der Vorrichtung zu dem einen oder den mehreren elektrischen Leiter(n) und/oder Wellenleiter(n).

8. Verfahren nach Anspruch 7, wobei Schritt a) Vorspannen, mittels eines flexiblen Elements, der Quantenvorrichtung hin zu dem ersten Abschnitt umfasst.

9. Verfahren nach Anspruch 8, wobei das flexible Element eine Leiterplatte umfasst, die elektrisch leitfähige Elemente und/oder Wellenleiter umfasst, und wobei Schritt c) elektrisches Anschließen der Quantenvorrichtung an das/die elektrisch leitfähige(n) Element(e) umfasst.

10. Verfahren nach Anspruch 7, wobei der Ausschnittabschnitt eine erste Tiefe aufweist und die Quantenvorrichtung eine erste Höhe aufweist, wobei die erste Höhe die erste Tiefe übersteigt.

11. Verfahren nach einem der Ansprüche 7-10, weiter umfassend den Schritt zum Bereitstellen einer elektromagnetischen Abschirmung, die einen Großteil des ersten und des zweiten Abschnitts umgibt.

12. Verfahren nach einem der Ansprüche 7-11, weiter umfassend den Schritt zum Kühlen der Baugruppe auf eine Temperatur unter 100K.

## Patentansprüche (Patentansprüche für folgende(n) Vertragsstaat(en): DE, GB)

1. Anordnung einer Quantenvorrichtung (16) und eines Probenhalters (10), wobei der Probenhalter Folgendes umfasst:
- einen ersten Abschnitt (12b), der einen ersten Hohlraum (14b) umfasst,
- einen zweiten Abschnitt (12a), der einen zweiten Hohlraum (14a) umfasst,
- erste Befestigungselemente, die eine Leiterplatte (18) umfassen, die die Quantenvorrichtung hin zu dem ersten Abschnitt vorspannt, wobei die Leiterplatte einen oder mehrere elektrische(n) Leiter und/oder Wellenleiter umfasst,
- Mittel (20) zum Vorspannen der Leiterplatte hin zu dem ersten Abschnitt oder Anbringen der Leiterplatte an dem ersten Abschnitt, und
- zweite Befestigungselemente (24), die dazu ausgelegt sind, den ersten und den zweiten Abschnitt aneinander zu befestigen,
wobei:
- die Quantenvorrichtung über mindestens einem Teil des ersten Hohlraums bereitgestellt ist und diesen abdeckt,
- die Quantenvorrichtung über mindestens einem Teil des zweiten Hohlraums bereitgestellt ist und diesen abdeckt,
- die Quantenvorrichtung durch die ersten Befestigungselemente an dem ersten Abschnitt befestigt ist und
- der/die elektrische(n) Leiter und/oder Wellenleiter mit der Quantenvorrichtung verbunden ist/sind und sich aus dem ersten und dem zweiten Abschnitt heraus erstreckt/erstrecken,
wobei der erste Abschnitt weiter einen Ausschnittabschnitt (121) bei dem ersten Hohlraum umfasst, wobei die Quantenvorrichtung in dem Ausschnittabschnitt bereitgestellt ist.

2. Anordnung nach Anspruch 1, wobei der Ausschnittabschnitt eine erste Tiefe aufweist und die Quantenvorrichtung eine erste Höhe aufweist, wobei die erste Höhe die erste Tiefe übersteigt.

3. Anordnung nach einem der vorstehenden Ansprüche, die weiter eine elektromagnetische Abschirmung (26) umfasst, die einen Großteil des ersten und des zweiten Abschnitts umgibt.

4. Anordnung nach einem der vorstehenden Ansprüche, auf eine Temperatur unter 100K gekühlt.

5. Verfahren nach einem der vorstehenden Ansprüche, wobei die Mittel zum Vorspannen der Leiterplatte hin zu dem ersten Abschnitt Schrauben/Bolzen, Klebstoff oder Haftmittel umfassen.

6. Verfahren zum Montieren einer Quantenvorrichtung in einer Anordnung nach einem der vorstehenden Ansprüche, wobei das Verfahren Folgendes umfasst:
a) Bereitstellen der Quantenvorrichtung in dem Ausschnittabschnitt und Befestigen der Quantenvorrichtung an dem ersten Abschnitt, um mindestens einen Abschnitt des ersten Hohlraums abzudecken,
b) Befestigen, anschließend an Schritt a), des zweiten Abschnitts an dem ersten Abschnitt, sodass die Quantenvorrichtung mindestens einen Abschnitt des zweiten Hohlraums abdeckt, und
c) Bereitstellen einer oder mehrerer elektrisch leitfähigen/leitfähiger oder wellenleitenden/wellenleitender Verbindung(en) von der Vorrichtung zu dem einen oder den mehreren elektrischen Leiter(n) und/oder Wellenleiter(n).

7. Verfahren nach Anspruch 6, wobei Schritt a) Vorspannen, mittels der Leiterplatte, der Quantenvorrichtung hin zu dem ersten Abschnitt umfasst.

8. Verfahren nach Anspruch 7, wobei Schritt c) elektrisches Anschließen der Quantenvorrichtung an das/die elektrisch leitfähige(n) Element(e) umfasst.

9. Verfahren nach Anspruch 6, wobei der Ausschnittabschnitt eine erste Tiefe aufweist und die Quantenvorrichtung eine erste Höhe aufweist, wobei die erste Höhe die erste Tiefe übersteigt.

10. Verfahren nach einem der Ansprüche 6-9, weiter umfassend den Schritt zum Bereitstellen einer elektromagnetischen Abschirmung, die einen Großteil des ersten und des zweiten Abschnitts umgibt.

11. Verfahren nach einem der Ansprüche 8-10, weiter umfassend den Schritt zum Kühlen der Baugruppe auf eine Temperatur unter 100K.

12. Verfahren nach einem der Ansprüche 6-11, wobei Schritt a) Befestigen der Quantenvorrichtung an dem ersten Abschnitt unter Verwendung von Schrauben/Bolzen, Klebstoff oder Haftmitteln umfasst.

## Revendications (Revendications pour l'(les) Etat(s) contractant(s) suivant(s): AT, BE, CH, DK, ES, FR, GR, IT, LI, LU, NL, SE, MC, PT, IE, SI, LT, LV, FI, RO, MK, CY, AL, TR, BG, CZ, EE, HU, PL, SK, HR, IS, MT, NO, RS, SM)

1. Assemblage d'un dispositif quantique (16) et d'un support d'échantillon (10), le support d'échantillon comprenant :
- une première partie (12b) comprenant une première cavité (14b),
- une deuxième partie (12a) comprenant une deuxième cavité (14b),
- des premiers éléments de fixation (18),
- un ou plusieurs conducteurs électriques et/ou guides d'onde (18, 22) et
- des deuxièmes éléments de fixation (24) configurés pour fixer les première et deuxième parties l'une à l'autre,
dans lequel :
- le dispositif quantique est disposé sur au moins une partie de la première cavité et recouvre celle-ci,
- le dispositif quantique est disposé sur au moins une partie de la deuxième cavité et recouvre celle-ci,
- le dispositif quantique est fixé à la première partie par les premiers éléments de fixation et
- le(s) conducteur(s) électrique(s) et/ou le(s) guide(s) d'onde est/sont connecté(s) au dispositif quantique et s'étend(ent) vers l'extérieur des première et deuxième parties,
**caractérisé en ce que** la première partie comprend en outre une partie découpée (121) au niveau de la première cavité, le dispositif quantique étant disposé dans la partie découpée.

2. Assemblage selon la revendication 1, dans lequel les premiers éléments de fixation comprennent un élément flexible sollicitant le dispositif quantique vers la première partie.

3. Assemblage selon la revendication 2, dans lequel l'élément flexible comprend une carte de circuit imprimé (18) et dans lequel le(s) conducteur (s) électrique(s) et/ou guides d'onde sont fournis comme des éléments électriquement conducteurs et/ou des guides d'onde de la carte de circuit imprimé.

4. Assemblage selon la revendication 1, dans lequel la partie découpée présente une première profondeur et le dispositif quantique présente une première hauteur, où la première hauteur dépasse la première profondeur.

5. Assemblage selon l'une quelconque des revendications précédentes, comprenant en outre un blindage électromagnétique (26) entourant une partie principale des première et deuxième parties.

6. Assemblage selon l'une quelconque des revendications précédentes, refroidi à une température inférieure à 100 K.

7. Procédé de montage d'un dispositif quantique dans un assemblage selon l'une quelconque des revendications précédentes, le procédé comprenant :
a) la disposition du dispositif quantique dans la partie découpée et la fixation du dispositif quantique à la première partie de manière à recouvrir au moins une partie de la première cavité,
b) la fixation de la deuxième partie à la première partie de manière à ce que le dispositif quantique recouvre au moins une partie de la deuxième cavité, et
c) la disposition d'une ou de plusieurs connexions électriquement conductrices ou de guidage d'onde à partir du dispositif vers les un ou plusieurs conducteurs électriques et/ou guides d'onde.

8. Procédé selon la revendication 7, dans lequel l'étape a) comprend la sollicitation, par le biais d'un élément flexible, du dispositif quantique vers la première partie.

9. Procédé selon la revendication 8, dans lequel l'élément flexible comprend une carte de circuit imprimé comprenant des éléments électriquement conducteurs et/ou des guides d'onde et dans lequel l'étape c) comprend la connexion électrique du dispositif quantique à l'élément / aux éléments électriquement conducteur(s).

10. Procédé selon la revendication 7, dans lequel la partie découpée présente une première profondeur et le dispositif quantique présente une première hauteur, où la première hauteur dépasse la première profondeur.

11. Procédé selon l'une quelconque des revendications 7 à 10, comprenant en outre l'étape de mise à disposition d'un blindage électromagnétique entourant une partie principale des première et deuxième parties.

12. Procédé selon l'une quelconque des revendications 7 à 11, comprenant en outre l'étape de refroidissement de l'assemblage à une température inférieure à 100 K.

## Revendications (Revendications pour l'(les) Etat(s) contractant(s) suivant(s): DE, GB)

1. Assemblage d'un dispositif quantique (16) et d'un support d'échantillon (10), le support d'échantillon comprenant :
- une première partie (12b) comprenant une première cavité (14b),
- une deuxième partie (12a) comprenant une deuxième cavité (14a),
- des premiers éléments de fixation comprenant une carte de circuit imprimé (18) sollicitant le dispositif quantique vers la première partie, la carte de circuit imprimé comprenant un ou plusieurs conducteurs électriques et/ou guides d'onde,
- des moyens (20) destinés à solliciter la carte de circuit imprimé vers la première partie ou à fixer la carte de circuit imprimé à la première partie, et
- des deuxièmes éléments de fixation (24) configurés pour fixer les première et deuxième parties l'une à l'autre,
dans lequel :
- le dispositif quantique est disposé sur au moins une partie de la première cavité et recouvre celle-ci,
- le dispositif quantique est disposé sur au moins une partie de la deuxième cavité et recouvre celle-ci,
- le dispositif quantique est fixé à la première partie par les premiers éléments de fixation et
- le(s) conducteur(s) électrique(s) et/ou le(s) guide(s) d'onde est/sont connecté(s) au dispositif quantique et s'étend(ent) vers l'extérieur des première et deuxième parties,
dans lequel la première partie comprend en outre une partie découpée (121) au niveau de la première cavité, le dispositif quantique étant disposé dans la partie découpée.

2. Assemblage selon la revendication 1, dans lequel la partie découpée présente une première profondeur et le dispositif quantique présente une première hauteur, où la première hauteur dépasse la première profondeur.

3. Assemblage selon l'une quelconque des revendications précédentes, comprenant en outre un blindage électromagnétique (26) entourant une partie principale des première et deuxième parties.

4. Assemblage selon l'une quelconque des revendications précédentes, refroidi à une température inférieure à 100 K.

5. Assemblage selon l'une quelconque des revendications précédentes, dans lequel les moyens destinés à solliciter la carte de circuit imprimé vers la première partie comprennent des vis/boulons, de la colle ou des adhésifs.

6. Procédé de montage d'un dispositif quantique dans un assemblage selon l'une quelconque des revendications précédentes, le procédé comprenant :
a) la disposition du dispositif quantique dans la partie découpée et la fixation du dispositif quantique à la première partie de manière à recouvrir au moins une partie de la première cavité,
b) la fixation, à la suite de l'étape a), de la deuxième partie à la première partie de manière à ce que le dispositif quantique recouvre au moins une partie de la deuxième cavité, et
c) la disposition d'une ou de plusieurs connexions électriquement conductrices ou de guidage d'onde à partir du dispositif vers les un ou plusieurs conducteurs électriques et/ou guides d'onde.

7. Procédé selon la revendication 6, dans lequel l'étape a) comprend la sollicitation, par le biais de la carte de circuit imprimé, du dispositif quantique vers la première partie.

8. Procédé selon la revendication 7, dans lequel l'étape c) comprend la connexion électrique du dispositif quantique à l'élément / aux éléments électriquement conducteur(s).

9. Procédé selon la revendication 6, dans lequel la partie découpée présente une première profondeur et le dispositif quantique présente une première hauteur, où la première hauteur dépasse la première profondeur.

10. Procédé selon l'une quelconque des revendications 6 à 9, comprenant en outre l'étape de mise à disposition d'un blindage électromagnétique entourant une partie principale des première et deuxième parties.

11. Procédé selon l'une quelconque des revendications 8 à 10, comprenant en outre l'étape de refroidissement de l'assemblage à une température inférieure à 100 K.

12. Procédé selon l'une quelconque des revendications 6 à 11, dans lequel l'étape a) comprend la fixation du dispositif quantique à la première partie à l'aide de vis/boulons, d'une colle ou d'adhésifs.
